# EUROPEAN PATENT SPECIFICATION

(11) **EP 3 607 587 B1**
(45) Date of publication and mention of the grant of the patent: **17.05.2023**
(21) Application number: 17901694.4
(22) Date of filing: 10.10.2017
(51) Int. Cl.: G06V 40/13, G06F 1/16

(54) **DISPLAY PANEL**
ANZEIGETAFEL
PANNEAU D'AFFICHAGE

(30) Priority: 24.03.2017 CN 201710182796
(43) Date of publication of application: 12.02.2020
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: SUN, Kuo, Beijing 100176 (CN); LIU, Fei, Beijing 100176 (CN); YIN, Haijun, Beijing 100176 (CN); LIU, Jianqiang, Beijing 100176 (CN)
(74) Representative: Hoffmann Eitle
(86) International application number: PCT/CN2017/105495
(87) International publication number: WO 2018/171167

(56) References cited:
- EP-A1- 2 527 913
- WO-A1-2012/166162
- WO-A1-2016/154378
- CN-A- 105 336 751
- CN-A- 105 373 772
- CN-A- 106 022 324
- CN-A- 106 295 580
- CN-A- 106 298 859
- CN-A- 106 847 872
- US-A1- 2016 266 695
- US-B1- 9 122 349

## Description

### TECHNICAL FIELD

This disclosure relates to a display technology, and more particularly, to a display panel.

### BACKGROUND

In recent years, smart phones have become more and more popular. A payment function in the smart phones provides great convenience to mobile phone users. The users can use mobile phones to pay for shopping or taking a taxi. Therefore, mobile phones having high security are needed to protect our property so that when the mobile phones are lost, they cannot be opened, and property and information in the mobile phones cannot be stolen. Fingerprint identification came into being in response to the need of secure mobile phones. In the current mainstream technology, structures for fingerprint identification are mainly disposed outside a display region of a screen. For example, some structures for fingerprint identification are provided on a primary key (Home key) of a mobile phone, and can be opened by sliding or pressing. Some structures for fingerprint identification are disposed on a back of a mobile phone. As such, when the mobile phone is held in a hand of a user, fingerprints of the user's fingers on the back of the mobile phone can be identified. Currently, there is no product where structures for fingerprint identification are disposed in a display region.

The document US2016/266695, for example, discloses a display panel with different substrates, light emitting units (pixels), shielding layers, and convergent lenses.

### BRIEF SUMMARY

In one aspect, the present invention provides a display apparatus which is defined by appended claim 1.

In another aspect, the present invention provides a display apparatus which is defined by appended claim 11.

Further advantageous embodiments of the present disclosure are indicated in the dependent claims.

### BRIEF DESCRIPTION OF THE DRAWINGS

The subject matter which is regarded as the disclosure is particularly pointed out and distinctly claimed in the claims at the conclusion of the specification. The foregoing and other objects, features, and advantages of the invention are apparent from the following detailed description taken in conjunction with the accompanying drawings in which:
Fig. 1 is a schematic view of a display apparatus for fingerprint identification according to one embodiment of the present disclosure;
Fig. 2 is a schematic view of an arrangement of a plurality of pixel regions in a display apparatus according to one embodiment of the present disclosure;
Fig. 3 is a schematic view of an arrangement of a plurality of pixel regions in a display apparatus according to one embodiment of the present disclosure.

### DETAILED DESCRIPTION

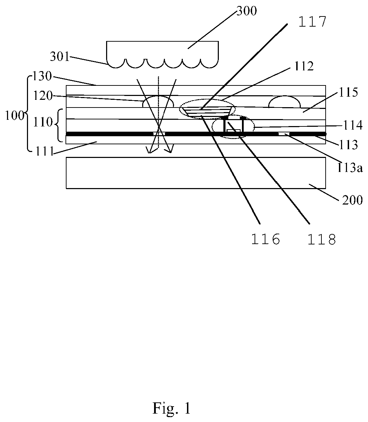

The present disclosure will be described in further detail with reference to the accompanying drawings and embodiments in order to provide a better understanding of the technical solutions of the present disclosure by those skilled in the art. Throughout the description of the disclosure, reference is made to Figs. 1-3. When referring to the figures, like structures and elements shown throughout are indicated with like reference numerals.

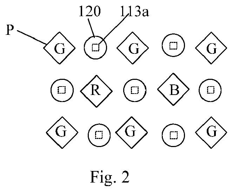

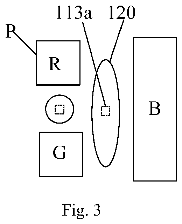

Fig. 1 shows a schematic view of a display apparatus for fingerprint identification according to one embodiment of the present disclosure. Fig. 2 shows a schematic view of a shape of convergent lens and an arrangement of pixel regions in a display apparatus according to one embodiment of the present disclosure. Fig. 3 shows a schematic view a shape of convergent lens and an arrangement of pixel regions in a display apparatus according to another embodiment of the present disclosure. As shown in Figs. 1 to 3, the display apparatus includes a display panel 100 and a fingerprint identification sensor 200. The display panel 100 includes a display substrate 110. The display substrate 110 is divided into a plurality of pixel regions P and a plurality of interval regions, each of which is located between two adjacent pixel regions P. A light emitting unit 112 is provided in each of the pixel regions P. The display panel 100 further includes a light shielding layer 113 provided on a non-light exiting side of the plurality of light emitting units 112. The light shielding layer 113 has a plurality of light transmitting holes 113a located in the interval regions respectively. A plurality of convergent lenses 120 are provided on a side of the light shielding layer 113 toward the light emitting units 112 and at locations corresponding to the light transmitting holes 113a respectively. The fingerprint identification sensor 200 is provided on a side of the light shielding layer 113 away from the light emitting units 112. The fingerprint identification sensor 200 is used to collect and identify an image of a fingerprint 301 located on a light exiting side of the display panel 100 through the light transmitting holes 113a when the display panel 100 emits light.

In one embodiment not claimed, the display substrate 110 may further include a base 111 and an array of thin film transistors 114 disposed on the base 111. The light emitting unit 112 may be an Organic Light-Emitting Diode unit (OLED) or a micro-LED provided on a side of the thin film transistor 114 away from the base 111. The light emitting unit 112 may comprise a first electrode 116, a second electrode 117 opposite the first electrode, and a light emitting function layer between the first electrode and the second electrode. The first electrode 116 is coupled to a drain 118 of the thin film transistor 114 . In one embodiment, the light emitting unit 112 may be a bottom light emission type. That is, the first electrode provided between the light-emitting function layer and the base is a transparent electrode and the second electrode is a non-transparent electrode. In another embodiment, the light emitting unit may be a top light emitting type. That is, the first electrode is a non-transparent electrode and the second electrode is a transparent electrode.

The light emitting unit 112 has a light exiting side and a non-light exiting side. The light exiting side is a side where light from the light-emitting unit 112 is directed to. The non-light exiting side is a side opposite to the light exiting side. The light exiting side of the display panel is the light exiting side of the light emitting unit. For a light emitting unit 112 of a bottom light emission type, the non-light exiting side thereof is a side of the light-emitting unit 112 away from the base 111. For a light emitting unit 112 of a top light emission type, the non-light exiting side thereof is a side of the light-emitting unit 112 toward the base 111. In one embodiment of the present disclosure, the light emitting unit 112 may be a light emitting unit of a top light emission type. That is, the light shielding layer 113 is located on a side of the light emitting unit 112 toward the base 111. The plurality of convergent lenses 120 are provided on a side of the corresponding light transmitting holes 113a away from the base 111.

In a display apparatus according to one embodiment of the present disclosure, in a display state, when a user's finger 300 is placed on a display region of a display panel 100, light emitted by light emitting units 112 is reflected by a fingerprint 301. Then, the reflected light is converged by convergent lenses 120 and passes through light transmitting holes 113a to travel toward a fingerprint identification sensor 200. Accordingly, the fingerprint identification sensor 200 identifies an image of the fingerprint based on the light emitted from each of the light transmitting holes 113a. Provision of the light transmitting holes 113a can prevent stray light outside the display apparatus from entering the fingerprint identification sensor 200 and influencing fingerprint identification effect. Provision of the convergent lenses 120 makes the light reflected by the fingerprint 301 more concentrated, so that the identification effect is better. As such, the embodiments of the present disclosure can realize fingerprint identification in a display region and achieve excellent fingerprint identification effect. Moreover, since the light shielding layer 113 is provided on the non-light exiting side of the light emitting units 112 and the light transmitting holes 113a are provided in the interval regions between the pixel regions, normal display is not affected.

In order to make the fingerprint identification sensor 200 to identify a complete image of a fingerprint, distributions of the light emitting holes 113a and the convergent lenses 120 should satisfy the following: when a finger 300 is placed in a display region of a display panel 100, convergent lenses 120 in the region where the finger 300 is located should ensure that light reflected at each position of the finger 300 can pass through the convergent lenses 120 and the light transmitting holes 113a to reach the fingerprint identification sensor 200. In one embodiment, the fingerprint identification sensor 200 may include a photoelectric sensor and an image processor. The photoelectric sensor is used to convert the received light into electrical signals and then send the electrical signals to the image processor. The image processor calculates to obtain an image of a fingerprint corresponding to each of the convergent lenses based on the received electrical signals, and then integrates them into a complete image of the fingerprint.

In one embodiment, an optical axis of a convergent lens 120 passes through a corresponding light transmitting hole 113a. In another embodiment, an optical axis of a convergent lens 120 coincides with a central axis of a corresponding light transmitting hole 113a. The term "coincides with" herein means that the optical axis of a convergent lens 120 coincides exactly or wholly with the central axis of a corresponding light transmitting hole 113a; or that the optical axis of a convergent lens 120 is parallel with the central axis of a corresponding light transmitting hole 113a and passes through the corresponding light transmitting hole 113a; or that the optical axis of a convergent lens 120 intersects the central axis of a corresponding light transmitting hole 113a and an angle formed by the two intersecting axes is smaller than 5 degree. In another embodiment, the light transmitting hole 113a may be located at a focus position of the corresponding convergent lens 120, so that light can pass through the light transmitting hole 113a as much as possible after the light is converged by the convergent lens 120, thereby improving the fingerprint identification effect.

In order to ensure that a light converged by the convergent lens 120 can sufficiently pass through a light transmitting hole 113a, and simultaneously prevent external stray light from passing through the light transmitting hole 113a to influence fingerprint identification effect, a diameter of the light transmitting hole 113a may be approximately in a range between about 1.5 µm and about 3.5 µm, preferably between about 2 µm and about 3 µm. In one embodiment, the light transmitting hole 113a may have a cylindrical column shape. In another embodiment, the light transmitting hole 113a may have a square column shape. When a light transmitting hole 113a has a square column shape, a length of the light transmitting hole 113a is a length of a diagonal of the light transmitting hole 113a at a horizontal plane. That is, as an orthographic projection of the light transmitting hole on the display substrate has a rectangular shape, the length of the light transmitting hole is a length of a diagonal of the rectangular shape, which has a value approximately between about 1.5 µm and about 3.5 µm, preferably between about 2µm and about 3 µm.

In one embodiment, the display panel 100 further includes a cover plate 130 opposite the display substrate 110. The cover plate 130 is located on a light exiting side of the plurality of the light emitting units 112 and supported by the plurality of the convergent lenses 120. As described above, in one embodiment of the present disclosure, the light emitting units 112 are a top light emission type. Accordingly, the cover plate 130 is located on the light exiting side of the plurality of light emitting units 112. That is, the cover plate 130 is located on a side of the plurality of light emitting units 112 away from the substrate 111. The plurality of convergent lenses 120 can not only converge the light but also support the cover plate 130 to maintain structural stability of the display panel 100. As such, both fingerprint identification in the display region and stability of the display panel 100 are achieved with a simple structure.

In one embodiment not claimed, the display substrate 110 further includes a pixel defining layer 115 disposed above the array of thin film transistors 114. The pixel defining layer 115 is formed with a plurality of grooves. The light emitting units 112 are disposed in the plurality of grooves. The plurality of convergent lenses 120 may be disposed on the pixel defining layer 115. A refractive index of the convergent lens 120 may be approximately between about 1.3 and about 1.8. In one embodiment, a refractive index of a convergent lens 120 is 1.7. A numerical range modified by "approximately" herein means that the upper and lower limits of the numerical range can vary by 10% thereof. A number modified by "about" herein means that the number can vary by 10% thereof.

The plurality of pixel regions P in the present disclosure may be arranged in different manners. An arrangement of the plurality of pixel regions not forming part of the invention is shown in Fig. 2. In said arrangement the plurality of pixel regions P is arranged in a plurality of rows and columns. An area of each of the pixel regions P is approximately the same. The convergent lens 120 may be a part of a sphere. A radius of a bottom surface of the convergent lens 120 is approximately between about 7 µm and about 12 µm, and a height of the convergent lens is approximately between about 1 µm and about 3 µm.

When the plurality of pixel regions P are uniformly arranged as described above, the plurality of convergent lenses 120 are also arranged uniformly. When a finger 300 touches the display panel 100, each of the convergent lenses 120 in the corresponding region collects light reflected by a circular region on the finger 300. As such, it is more convenient for the fingerprint identification sensor 200 to acquire an entire image of a fingerprint based on the light reflected back from each circular region.

Fig. 3 shows an arrangement of the plurality of pixel regions P according to one embodiment of the present disclosure. As shown in Fig. 3, the plurality of pixel regions P is arranged in a plurality of columns. In any two adjacent columns, an area of a pixel region P in one column is larger than that of a pixel region P in the other column. A convergent lens 120 located between the two adjacent columns of pixel regions P is a part of an ellipsoid. As shown in Fig. 3, an area of a blue pixel region B on the right column is approximately a sum of areas of a red pixel region R and a green pixel region G on the left column. A bottom surface of the convergent lens between the left column pixel region P and the right column pixel region P is elliptical to make full use of the interval region. For pixel regions P of the same column, areas of the pixel regions P may be the same. In one embodiment, the convergent lens 120 between the two adjacent pixel regions P may be a part of a sphere.

In one embodiment, when a convergent lens 120 is a part of an ellipsoid, a long axis of a bottom surface of the elliptical shape of the convergent lens 120 is approximately between about 12 µm and about 20 µm. A short axis thereof is approximately between about 6 µm and about 12 µm. A height of the convergent lens is approximately between about 1 µm and about 3 µm.

A material of the light-shielding layer 113 of the present disclosure is not particularly limited here. In one embodiment, it may be made of a metallic material or an opaque polyester material.

In the display apparatus described above, in a display mode, when a user's finger is placed in a display region of a display panel, light emitted by the light emitting unit is reflected by a fingerprint. The reflected light is then converged by convergent lenses, passes through light transmitting holes, and travels toward a fingerprint identification sensor. The fingerprint identification sensor identifies a fingerprint image based on the light emitted from each of the light transmitting holes. Provision of the light transmitting holes can prevent stray light outside the display apparatus from entering the fingerprint identification sensor and influence the fingerprint identification effect. Provision of the convergent lens makes the light reflected by the fingerprint more concentrated. As such, the identification effect is better.

The descriptions of the various embodiments of the present disclosure have been presented for purposes of illustration, but are not intended to be exhaustive or limited to the embodiments disclosed. The terminology used herein was chosen to best explain the principles of the embodiments, the practical application or technical improvement over technologies found in the marketplace, or to enable others of ordinary skill in the art to understand the embodiments disclosed herein.

Description of symbols in the drawings:
100: display panel
110: display substrate
111: base
112: light-emitting unit
113: light shielding layer
113a: light transmitting hole
114: thin-film transistor
115: pixel defining layer
116: first electrode
117: second electrode
118: drain of thin film transistor
120: convergent lens
130: cover plate
200: fingerprint identification sensor
300: finger
301: fingerprint
P: pixel region
R: red pixel region
G: green pixel region
B: blue pixel region

## Claims

1. A display panel comprising:
a display substrate (110) and a plurality of convergent lenses (120), the display substrate (110) having a plurality of pixel regions (P) and a plurality of interval regions between the pixel regions (P), the plurality of pixel regions (P) are arranged in a plurality of columns, and in any two adjacent columns, an area of a pixel region (P) in one column is larger than an area of a pixel region (P) in the other column;
wherein the display substrate (110) comprises a light shielding layer (113) on a non-light exiting side of a plurality of light emitting units (112) in the plurality of pixel regions (P), the light shielding layer (113) having a plurality of light transmitting holes (113a) in the plurality of interval regions, and
the plurality of convergent lenses (120) are on a side of the light shielding layer (113) toward the plurality of light emitting units (120) and at locations corresponding to the light transmitting holes (113a) respectively, and each of the convergent lenses (120) between the two adjacent columns of the pixel regions (P) is a part of an ellipsoid.

2. The display panel according to claim 1, wherein an orthographic projection of each of the convergent lenses (120) on the display substrate (110) covers an orthographic projection of one of the light transmitting holes (113a) on the display substrate (110) respectively.

3. The display panel according to claim 1 or claim 2, wherein optical axes of the plurality of convergent lenses (120) pass through the corresponding light transmitting holes (113a) respectively.

4. The display panel according to claim 3, wherein the optical axes of the plurality of convergent lenses (120) coincide with central axes of the corresponding light transmitting holes (113a) respectively.

5. The display panel according to claim 4, wherein the plurality of light transmitting holes (113a) are located at focal positions of the corresponding convergent lenses (120) respectively.

6. The display panel according to any one of the claims 1-5, wherein the display panel (100) further includes a cover plate (130) opposite the display substrate (110), and the cover plate (130) is on a light exiting side of the plurality of light emitting units (112) and supported on the plurality of convergent lenses (120).

7. The display panel according to claim 1, wherein a long axis of a bottom surface of each of the convergent lenses (120) is approximately between 12 µm and 20 µm, a short axis thereof is approximately between 6 µm and 12 µm, and a height of each of the convergent lenses (120) is approximately between 1 µm and 3µm.

8. The display panel according to any one of claims 1-7, wherein a refractive index of each of the convergent lenses (120) is approximately between 1.3 and 1.8.

9. The display panel according to any one of claims 1-8, wherein a diameter or length of each of the light transmitting holes (113a) is approximately between 2 µm and 3 µm.

10. The display panel according to any one of claims 1-9, wherein the light-shielding layer (113) is made of a metallic or an opaque polyester material.

11. A display apparatus comprising:
the display panel (100) according to any one of claims 1-10,
a fingerprint identification sensor (200),
wherein the fingerprint identification sensor (200) is on a side of the light shielding layer (113) away from the plurality of light emitting units (112), and the fingerprint identification sensor (200) is configured to collect and identify an image of fingerprint (301) on a light exiting side of the display panel (100) through the light transmitting holes (113a) when the display panel (100) emits light.

## Patentansprüche

1. Anzeigefeld, umfassend:
ein Anzeigesubstrat (110) und eine Vielzahl von konvergierenden Linsen (120), wobei das Anzeigesubstrat (110) eine Vielzahl von Pixelbereichen (P) und eine Vielzahl von Intervallbereiche zwischen den Pixelbereichen (P) aufweist, wobei die Vielzahl von Pixelbereichen (P) in einer Vielzahl von Spalten angeordnet ist und in zwei beliebigen angrenzenden Spalten eine Fläche eines Pixelbereichs (P) in einer Spalte größer ist als eine Fläche eines Pixelbereichs (P) in der anderen Spalte;
wobei das Anzeigesubstrat (110) eine lichtabschirmende Schicht (113) auf einer Nichtaustrittsseite von Licht einer Vielzahl von Licht emittierenden Einheiten (112) in der Vielzahl von Pixelbereichen (P) umfasst, wobei die lichtabschirmende Schicht (113) eine Vielzahl von lichtdurchlässigen Löchern (113a) in der Vielzahl von Intervallbereichen aufweist, und
die Vielzahl von konvergierenden Linsen (120) an einer Seite der lichtabschirmenden Schicht (113) zu der Vielzahl von Licht emittierenden Einheiten (120) hin und an Stellen, die jeweils den lichtdurchlässigen Löchern (113a) entsprechen, ist, und jede der konvergierenden Linsen (120) zwischen den zwei angrenzenden Spalten der Pixelbereiche (P) ein Teil eines Ellipsoids ist.

2. Anzeigefeld nach Anspruch 1, wobei eine orthographische Projektion von jeder der konvergierenden Linsen (120) auf das Anzeigesubstrat (110) eine orthographische Projektion von jeweils einem der lichtdurchlässigen Löcher (113a) auf dem Anzeigesubstrat (110) abdeckt.

3. Anzeigefeld nach Anspruch 1 oder Anspruch 2, wobei optische Achsen der Vielzahl von konvergierenden Linsen (120) jeweils durch die entsprechenden lichtdurchlässigen Löcher (113a) durchgehen.

4. Anzeigefeld nach Anspruch 3, wobei die optischen Achsen der Vielzahl von konvergierenden Linsen (120) mit Mittelachsen der jeweils entsprechenden lichtdurchlässigen Löcher (113a) übereinstimmen.

5. Anzeigefeld nach Anspruch 4, wobei die Vielzahl von lichtdurchlässigen Löchern (113a) an Fokuspositionen der jeweils entsprechenden konvergierenden Linsen (120) gelegen ist.

6. Anzeigefeld nach einem der Ansprüche 1-5, wobei das Anzeigefeld (100) weiter eine Abdeckplatte (130) gegenüber dem Anzeigesubstrat (110) einschließt, und die Abdeckplatte (130) an einer Lichtaustrittsseite der Vielzahl von Licht emittierenden Einheiten (112) ist und von der Vielzahl von konvergierenden Linsen (120) gestützt wird.

7. Anzeigefeld nach Anspruch 1, wobei eine lange Achse einer Bodenoberfläche von jeder der konvergierenden Linsen (120) etwa zwischen 12 µm und 20 µm ist, eine kurze Achse davon etwa zwischen 6 µm und 12 µm ist und eine Höhe von jeder der konvergierenden Linsen (120) etwa zwischen 1 µm und 3 µm ist.

8. Anzeigefeld nach einem der Ansprüche 1-7, wobei ein Brechungsindex von jeder der konvergierenden Linsen (120) etwa zwischen 1,3 und 1,8 ist.

9. Anzeigefeld nach einem der Ansprüche 1 - 8, wobei ein Durchmesser oder eine Länge von jedem der lichtdurchlässigen Löcher (113a) etwa zwischen 2 µm und 3 µm ist.

10. Anzeigefeld nach einem der Ansprüche 1 - 9, wobei die lichtabschirmende Schicht (113) aus einem metallischen oder einem undurchsichtigen Polyestermaterial hergestellt ist.

11. Anzeigeeinrichtung, umfassend:
das Anzeigefeld (100) nach einem der Ansprüche 1 - 10,
einen Fingerabdruck-Identifizierungssensor (200),
wobei der Fingerabdruck-Identifizierungssensor (200) an einer Seite der lichtabschirmenden Schicht (113) weg von der Vielzahl von Licht emittierenden Einheiten (112) ist und der Fingerabdruck-Identifizierungssensor (200) konfiguriert ist, um ein Bild von Fingerabdruck (301) an einer Lichtaustrittsseite des Anzeigefelds (100) durch die lichtdurchlässige Löchern (113a) zu erfassen und zu identifizieren, wenn das Anzeigefeld (100) Licht emittiert.

## Revendications

1. Panneau d'affichage comprenant :
un substrat d'affichage (110) et une pluralité de lentilles convergentes (120), le substrat d'affichage (110) présentant une pluralité de régions de pixel (P) et une pluralité de régions d'intervalle entre les régions de pixel (P), la pluralité de régions de pixel (P) sont agencées dans une pluralité de colonnes et, dans deux quelconques colonnes adjacentes, une zone d'une région de pixel (P) dans une colonne est plus grande qu'une région de pixel (P) dans l'autre colonne ;
dans lequel le substrat d'affichage (110) comprend une couche pare-lumière (113) sur un côté de non-sortie de lumière d'une pluralité d'unités électroluminescentes (112) dans la pluralité de régions de pixel (P), la couche pare-lumière (113) présentant une pluralité de trous de transmission de lumière (113a) dans la pluralité de régions d'intervalle, et
la pluralité de lentilles convergentes (120) sont sur un côté de la couche pare-lumière (113) vers la pluralité d'unités électroluminescentes (120) et à des emplacements correspondant aux trous de transmission de lumière (113a) respectivement, et chacune des lentilles convergentes (120) entre les deux colonnes adjacentes des régions de pixel (P) fait partie d'un ellipsoïde.

2. Panneau d'affichage selon la revendication 1, dans lequel une projection orthographique de chacune des lentilles convergentes (120) sur le substrat d'affichage (110) couvre une projection orthographique d'un des trous de transmission de lumière (113a) sur le substrat d'affichage (110) respectivement.

3. Panneau d'affichage selon la revendication 1 ou la revendication 2, dans lequel des axes optiques de la pluralité de lentilles convergentes (120) passent à travers les trous de transmission de lumière (113a) correspondants respectivement.

4. Panneau d'affichage selon la revendication 3, dans lequel les axes optiques de la pluralité de lentilles convergentes (120) coïncident avec des axes centraux des trous de transmission de lumière (113a) correspondants respectivement.

5. Panneau d'affichage selon la revendication 4, dans lequel la pluralité de trous de transmission de lumière (113a) sont situés au niveau de positions focales des lentilles convergentes (120) correspondantes respectivement.

6. Panneau d'affichage selon l'une quelconque des revendications 1-5, dans lequel le panneau d'affichage (100) inclut en outre une plaque de recouvrement (130) opposée au substrat d'affichage (110), et la plaque de recouvrement (130) est sur un côté de sortie de lumière de la pluralité d'unités électroluminescentes (112) et supporté sur la pluralité de lentilles convergentes (120).

7. Panneau d'affichage selon la revendication 1, dans lequel un axe long d'une surface inférieure de chacune des lentilles convergentes (120) est approximativement entre 12 µm et 20 µm, un axe court de celle-ci est approximativement entre 6 µm et 12 µm et une hauteur de chacune des lentilles convergentes (120) est approximativement entre 1 µm et 3 µm.

8. Panneau d'affichage selon l'une quelconque des revendications 1-7, dans lequel un indice de réfraction de chacune des lentilles convergentes (120) est approximativement entre 1,3 et 1,8.

9. Panneau d'affichage selon l'une quelconque des revendications 1-8, dans lequel un diamètre ou une longueur de chacun des trous de transmission de lumière (113a) est approximativement entre 2 µm et 3 µm.

10. Panneau d'affichage selon l'une quelconque des revendications 1-9, dans lequel la couche pare-lumière (113) est constituée d'un matériau métallique ou polyester opaque.

11. Appareil d'affichage comprenant :
le panneau d'affichage (100) selon l'une quelconque des revendications 1-10,
un capteur d'identification d'empreintes digitales (200),
dans lequel le capteur d'identification d'empreintes digitales (200) est sur un côté de la couche pare-lumière (113) à l'écart de la pluralité d'unités d'émission de lumière (112) et le capteur d'identification d'empreintes digitales (200) est configuré pour collecter et identifier une image d'empreinte digitale (301) sur un côté de sortie de lumière du panneau d'affichage (100) à travers les trous de transmission de lumière (113a) lorsque le panneau d'affichage (100) émet de la lumière.
